(19) Europäisches Patentamt

European Patent Office

Office européen des brevets

(11) **EP 4 528 338 A1**

(12) # EUROPEAN PATENT APPLICATION

(43) Date of publication:
**26.03.2025 Bulletin 2025/13**

(21) Application number: **24198420.2**

(22) Date of filing: **04.09.2024**

(51) International Patent Classification (IPC):
**G02B 1/00** (2006.01)   **G02B 5/28** (2006.01)
**G02B 26/00** (2006.01)   **G02F 1/21** (2006.01)
**G02B 5/20** (2006.01)

(52) Cooperative Patent Classification (CPC):
**G02B 1/002; G02B 5/201; G02B 5/288;**
**G02B 26/001;** G02B 2207/101; G02F 1/213

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **20.09.2023 KR 20230125849**

(71) Applicant: **Samsung Electronics Co., Ltd**
**Suwon-si, Gyeonggi-do 16677 (KR)**

(72) Inventors:
• **Lee, Suyeon**
  **16678 Suwon-si, Gyeonggi-do (KR)**
• **Mun, Sangeun**
  **16678 Suwon-si, Gyeonggi-do (KR)**
• **Kim, Hyochul**
  **16678 Suwon-si, Gyeonggi-do (KR)**
• **Roh, Sookyoung**
  **16678 Suwon-si, Gyeonggi-do (KR)**

(74) Representative: **Grünecker Patent- und**
**Rechtsanwälte**
**PartG mbB**
**Leopoldstraße 4**
**80802 München (DE)**

(54) **SPECTRAL FILTER AND ELECTRONIC DEVICE INCLUDING THE SAME**

(57)    A spectral filter includes a first resonance structure and a meta device disposed on the first resonance structure. The meta device includes a plurality of first beam steering regions, in which an incidence angle of an incident light is adjusted differently to be emitted, wherein each first beam steering region of the plurality of first beam steering regions includes a plurality of nanostructures, each nanostructure of the plurality of nanostructures having a shape dimension corresponding to a subwavelength of the incident light.

FIG. 1

EP 4 528 338 A1

## Description

BACKGROUND

1. Field

The disclosure relates to a spectral filter and an electronic device including the spectral filter.

2. Description of the Related Art

In the related art, wavelength bands of image sensors are classified into three sections, i.e., red (R), green (G), and blue (B) wavelength bands. However, to improve the color expression accuracy and object recognition performance, an image sensor with a spectral filter in which wavelength bands are divided into more sections needs to be developed.

Spectral filters may be designed based on a Fabry-Perot filter, and a peak transmission wavelength may be determined by adjusting a material and a thickness of a cavity provided in the Fabry-Perot filter. In such a design method, a spectral wavelength range may be limited by a processable material of the Fabry-Perot filter.

SUMMARY

Provided are a spectral filter capable of implementing various transmission wavelength bands and an electronic device including the spectral filter.

Additional aspects will be set forth in part in the description which follows and, in part, will be apparent from the description, or may be learned by practice of the presented embodiments of the disclosure.

According to an aspect of an example embodiment of the disclosure, a spectral filter includes a first resonance structure, and a meta device disposed on the first resonance structure, the meta device including a plurality of first beam steering regions, in which an incidence angle of an incident light is adjusted differently to be emitted, wherein each first beam steering region of the plurality of first beam steering regions includes a plurality of nanostructures, each nanostructure of the plurality of nanostructures having a shape dimension corresponding to a sub-wavelength of the incident light.

The first resonance structure may include a plurality of first resonator regions that exhibit a first resonance wavelength with respect to a vertically incident light, the plurality of first beam steering regions may respectively face the plurality of first resonator regions, and at least one of the plurality of first resonator regions may transmit light in a wavelength band different from the first resonance wavelength.

The plurality of nanostructures in one first beam steering region are arranged according to an arrangement rule that is different from an arrangement rule of the plurality of nanostructures in another first beam steering region.

The spectral filter may operate as a plurality of unit filters with the same number as the number of the plurality of first beam steering regions, and central transmission wavelengths respectively exhibited by the plurality of unit filters may be the first resonance wavelength or less and fall within a range of 30 % or more of the first resonance wavelength.

The first resonance structure may include a first reflector and a second reflector disposed to face each other and spaced apart from each other, and a cavity layer disposed between the first reflector and the second reflector.

Each of the first reflector and the second reflector may independently include a distributed Bragg reflector (DBR).

The spectral filter may further include a second resonance structure a second resonance structure including a plurality of second resonator regions that exhibit a second resonance wavelength with respect to a vertically incident light, the second resonance wavelength being different from the first resonance wavelength, the meta device may further include a plurality of second beam steering regions respectively facing the plurality of second resonator regions, and at least one of the plurality of second resonator regions may transmit light in a wavelength band different from the second resonance wavelength.

Each of the first resonance structure and the second resonance structure may independently include a first reflector and a second reflector disposed to face each other and spaced apart from each other, and a cavity layer disposed between the first reflector and the second reflector.

A thickness of the cavity layer of the second resonance structure may be different from a thickness of the cavity layer of the first resonance structure.

The cavity layer of the second resonance structure may include a dielectric pattern, the dielectric pattern including two types of dielectrics having different refractive indices.

A thickness of the cavity layer of the second resonance structure may be equal to a thickness of the cavity layer of the first resonance structure.

The cavity layer of the first resonance structure and the cavity layer of the second resonance structure may have different effective refractive indices.

The spectral filter may operate as a plurality of unit filters having different transmission wavelength bands, and the number of the plurality of unit filters is a sum of the number of the first beam steering region and the number of the plurality of second beam steering regions.

The spectral filter may further include a buffer layer disposed between the first resonance structure and the meta device and supporting the plurality of nanostructures of each first beam steering region.

The spectral filter may further include a band pass filter disposed between the first resonance structure and the meta device.

The plurality of nanostructures of the meta device may be arranged in two layers.

According to an aspect of an example embodiment of the disclosure, an image sensor includes a sensor substrate including a plurality of light sensing cells, the plurality of light sensing cells being configured to sense a light; and a plurality of spectral filters disposed on the sensor substrate, wherein each spectral filter of the plurality of spectral filters includes: a first resonance structure; and a meta device disposed on the first resonance structure and including a plurality of first beam steering regions, in which an incidence angle of an incident light is adjusted differently to be emitted, and wherein each first beam steering region of the plurality of first beam steering regions includes a plurality of nanostructures, each nanostructure of the plurality of nanostructures having a shape dimension corresponding to a sub-wavelength of the incident light.

Each spectral filter of the plurality of spectral filters may further include a second resonance structure, the second resonance structure including a plurality of second resonator regions that exhibit a second resonance wavelength with respect to a vertically incident light, the second resonance wavelength being different from a first resonance wavelength of the first resonance structure; the meta device may further include a plurality of second beam steering regions respectively facing the plurality of second resonator regions; and at least one of the plurality of second resonator regions transmits a light in a wavelength band different from the second resonance wavelength.

An arrangement of the plurality of nanostructures in a first beam steering region corresponding to a spectral filter located at a center region of the image sensor among the plurality of spectral filters is different from an arrangement of the plurality of nanostructures in a first beam steering region corresponding to a spectral filter located at a periphery of the image sensor.

According to an aspect of an example embodiment of the disclosure, an electronic device includes a lens assembly and an image sensor configured to sense light transmitted through the lens assembly, wherein the image sensor includes a sensor substrate including a plurality of light sensing cells sensing light, and a plurality of spectral filters disposed on the sensor substrate, each spectral filter of the plurality of spectral filters includes a first resonance structure, a meta device disposed on the first resonance structure and including a plurality of first beam steering regions, in which an incidence angle of an incident light is adjusted differently to be emitted, and wherein each first beam steering region of the plurality of first beam steering region includes a plurality of nanostructures, each nanostructure of the plurality of nanostructures having a shape dimension corresponding to a sub-wavelength of the incident light.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a cross-sectional view for conceptually explaining a structure of a spectral filter according to an example embodiment;

FIG. 2 is a plan view showing an arrangement of unit filters included in the spectral filter according to an example embodiment;

FIG. 3 is a cross-sectional view showing a schematic structure of the spectral filter according to an example embodiment;

FIG. 4 is a graph showing a transmission spectrum according to a resonance structure provided in the spectral filter of FIG. 3 at various incidence angles;

FIG. 5 is a cross-sectional view showing a schematic structure of a spectral filter according to an example embodiment;

FIG. 6 is a cross-sectional view showing a schematic structure of a spectral filter according to an example embodiment;

FIG. 7 is a cross-sectional view showing a schematic structure of a spectral filter according to an example embodiment;

FIG. 8 is a cross-sectional view showing a schematic structure of a spectral filter according to an example embodiment;

FIG. 9 is a cross-sectional view showing a schematic structure of a spectral filter according to an example embodiment;

FIG. 10 is a graph showing a transmission spectrum according to a resonance structure provided in the spectral filter of FIG. 9 at various incidence angles;

FIG. 11 is a cross-sectional view showing a schematic structure of a spectral filter according to an example embodiment;

FIG. 12 is a cross-sectional view showing a schematic structure of a spectral filter according to an example embodiment;

FIG. 13 is a cross-sectional view showing a schematic structure of a spectral filter according to an example embodiment;

FIG. 14 is a block diagram of an image sensor according to an example embodiment;

FIG. 15 is a conceptual diagram for explaining a chief ray angle (CRA) of light incident on an image sensor according to an example embodiment;

FIGS. 16 to 18 are cross-sectional views showing structures of spectral filters at a plurality of positions having different CRAs in an image sensor according to an example embodiment;

FIG. 19 is a block diagram schematically showing an electronic device according to an example embodiment; and

FIG. 20 is a block diagram schematically showing a camera module provided in the electronic device of FIG. 19.

## DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The example embodiments will be described in detail below with reference to accompanying drawings. The embodiments described herein are provided merely as an example, and may be embodied in many different forms. In the drawings, like reference numerals denote like components, and sizes of components in the drawings may be exaggerated for convenience of explanation.

Hereinafter, it will be understood that when a component is referred to as being "above" or "on" another component, the component may be directly on the other component or over the other component in a non-contact manner.

It will be understood that although the terms "first," "second," etc. may be used herein to describe various components, these components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprises" another component, the portion may not exclude another component but may further comprise another component unless the context states otherwise.

Also, the terms "... unit" and "... module" used herein specify a unit for processing at least one function or operation, and this may be implemented with hardware or software or a combination of hardware and software.

The use of the terms "a", "an", and "the" and similar referents are to be construed to cover both the singular and the plural.

Also, the steps of all methods described herein may be performed in any suitable order unless otherwise indicated herein or otherwise clearly contradicted by context. Also, the use of all exemplary terms (for example, etc.) provided herein, are intended merely to better illuminate the technical ideas and does not pose a limitation on the scope of rights unless otherwise claimed.

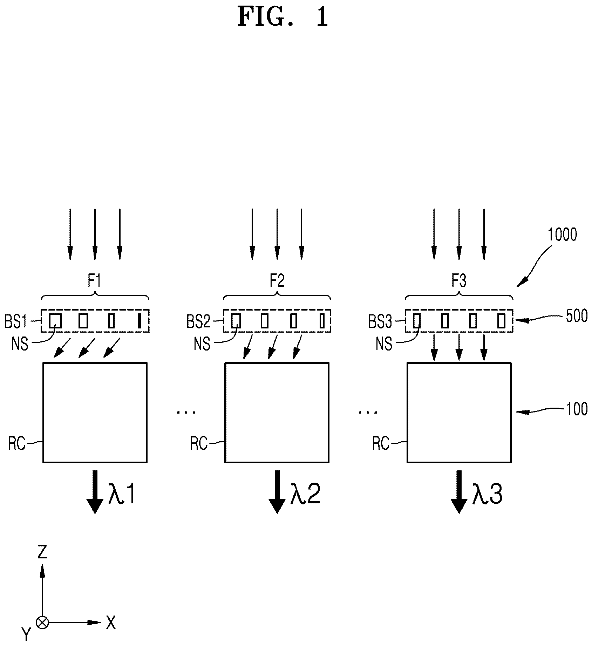

FIG. 1 is a cross-sectional view for conceptually explaining a structure of a spectral filter 1000 according to an example embodiment.

The spectral filter 1000 includes a resonance structure 100 and a meta device 500. The meta device 500 is disposed on the resonance structure 100 and includes a plurality of beam steering regions BS1, BS2, and BS3 that adjust an angle of incident light and emit the incident light.

Each of the beam steering regions BS1, BS2, and BS3 includes a plurality of nanostructures NS, and emit the incident light by adjusting the angle of incident light according to shapes and an arrangement of the nanostructures NS. For example, as shown, lights perpendicularly incident on the meta device 500 may be deflected by a certain angle while passing through the beam steering regions BS1, BS2, and BS3 and emitted.

The nanostructures NS may have different arrangement rules in the beam steering regions BS1, BS2, and BS3. At least one of a shape, a size (e.g., a width and/or a height), a distance between nanostructures, an arrangement form, etc. of the nanostructures NS may be different in each of the beam steering regions BS1, BS2, and BS3. As shown, the nanostructures NS of the same shape may be provided in the beam steering regions BS1, BS2, and BS3, and a rule in which the nanostructures NS of different widths are disposed may be determined according to positions of the beam steering regions, so that angles at which incident light is deflected and emitted may be adjusted.

For example, the angles at which the beam steering regions BS1, BS2, and BS3 deflect incident light may be $\theta 1$, $\theta 2$, and $\theta 3$, and $\theta 1 > \theta 2 > \theta 3$. The tendency of widths of the nanostructures NS to decrease in one direction (e.g., X direction) may be the greatest in the beam steering region BS1 and be reduced in the order of the beam steering regions BS2 and BS3. The beam steering region BS3 may include the nanostructures NS having a constant width so as to almost not deflect incident light. In FIG. 1, $\theta 3$ is shown as 0 degree. However, the arrangement rule of the nanostructures NS and a resulting deflection angle of incident light shown in FIG. 1 are only examples and may be modified in various ways.

The resonance structure 100 includes a plurality of resonator regions RC, and light perpendicularly incident on the meta device 500 are deflected at a different angle while passing through the beam steering regions BS1, BS2, and BS3 and incident on the resonator regions RC that face each other.

The plurality of resonator regions RC may be Fabry-Perot-based resonators each including two reflectors and a cavity therebetween. Light incident on the resonator region RC travels back and forth inside the resonator region RC, causing constructive interference and destructive interference in this process. In addition, light having a specific central wavelength that satisfies a constructive interference condition may be emitted to a lower surface of the resonator region RC. Such a specific central wavelength will hereinafter be referred to as a resonance wavelength. All of the plurality of resonator regions RC may be designed to have the same resonance wavelength.

A resonance wavelength is designed based on light of normal incidence, that is, light incident at an incidence angle of 0 degree. In other words, the resonator region RC operates as a filter that transmits light of the same wavelength as the designed resonance wavelength with respect to the vertically incident light, but operates as a filter that transmits light of a different wavelength with respect to light that is incident at an oblique angle. When the resonance wavelength of the resonator region RC is $\lambda_R$, the beam steering region BS1 and the resonator region RC facing the beam steering region BS1 may operate as a first unit filter F1 that transmits light of a first wavelength $\lambda 1$, the beam steering region BS2 and the resonator region RC facing the beam steering region BS2 may operate as a second unit filter F2 that transmits light of a second wavelength $\lambda 2$, and the beam steering region BS3 and the resonator region RC facing the beam steering region BS3 may operate as a third unit filter F3 that transmits light of a third wavelength $\lambda 3$.

The transmission wavelengths $\lambda 1$, $\lambda 2$, and $\lambda 3$ of the first to third unit filters F1, F2, and F3 respectively mean central wavelengths of wavelength bands of light transmitted by the first to third unit filters F1, F2, and F3.

According to the arrangement form of the nanostructures NS of each of the beam steering regions BS1, BS2, and BS3, at least one of $\lambda 1$, $\lambda 2$, or $\lambda 3$ may be different from $\lambda_R$.

The angles $\theta 1$, $\theta 2$, and $\theta 3$ at which the beam steering regions BS1, BS2, and BS3 deflect the incident light have a relationship of $\theta 1 > \theta 2 > \theta 3$, and the wavelengths $\lambda 1$, $\lambda 2$, and $\lambda 3$ of light transmitted through the first to third unit filters F1, F2, and F3 may have a relationship of $\lambda 1 < \lambda 2 < \lambda 3$. In the drawing, an angle $\theta 3$ at which the beam steering region BS3 deflects the incident light may be 0 degree, and $\lambda 3$ may be the same as $\lambda_R$.

As described above, the spectral filter 1000 according to an example embodiment may utilize the plurality of resonator regions RC designed to have the same resonance wavelength with respect to the vertically incident light while forming unit filters in association with the beam steering regions, thereby exhibiting different and various transmission wavelength bands.

The cross-sectional view shown in FIG. 1 illustrates that the first to third unit filters F1, F2, and F3 having transmission wavelengths $\lambda 1$, $\lambda 2$, and $\lambda 3$ are formed by using three resonator regions RC having the same resonance wavelength $\lambda_R$, but the disclosure is not limited thereto. For example, more types of beam steering regions that differently adjust the angle of incident light may be provided on the resonance structure 100, and unit filters having transmission wavelengths of $\lambda 4$, $\lambda 5$, $\lambda 6$, etc.

may be further formed. Alternatively, the illustrated beam steering regions BS1, BS2, and BS3 may be respectively disposed on a plurality of resonator regions having different resonance wavelengths, and the unit filters having transmission wavelengths $\lambda 4$, $\lambda 5$, $\lambda 6$, etc. may be further formed.

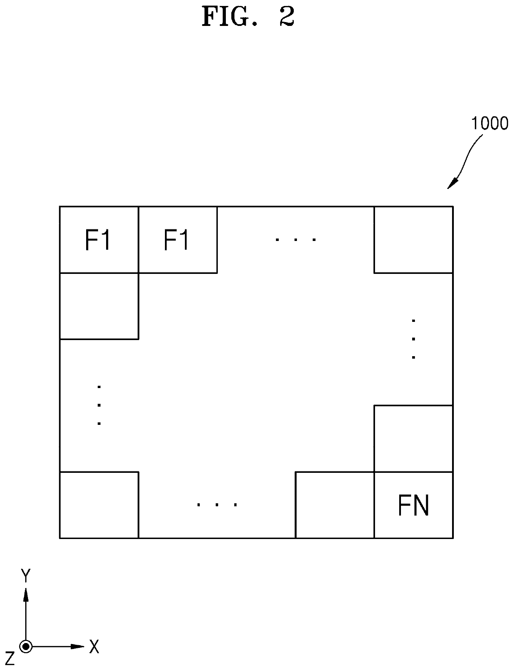

FIG. 2 is a plan view showing an arrangement of unit filters included in the spectral filter 1000 according to an example embodiment.

N unit filters designed in the manner described in FIG. 1 may be two-dimensionally arranged in X and Y directions. The N unit filters may respectively exhibit transmission wavelengths $\lambda 1$ to $\lambda N$.

Resonator regions respectively included in the N unit filters may all be designed to have the same resonance wavelength, and in this case, beam steering regions included in the N unit filters may all have different nanostructure arrangement rules.

Alternatively, the N unit filters may be formed by combining a plurality of types of resonator regions and a plurality of beam steering regions having different arrangement rules.

Hereinafter, some example embodiments of spectral filters implemented in various forms will be described.

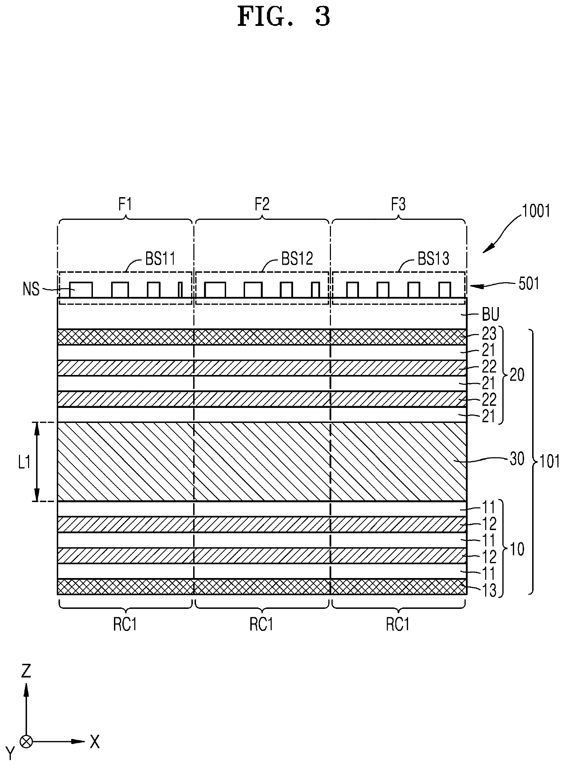

FIG. 3 is a cross-sectional view showing a schematic structure of a spectral filter 1001 according to an example embodiment.

The spectral filter 1001 includes a first resonance structure 101 and a meta device 501.

The first resonance structure 101 includes a first reflector 10 and a second reflector 20 that face each other, and a cavity layer 30 disposed between the first reflector 10 and the second reflector 20.

The cavity layer 30, which is a resonance layer, may include a semiconductor material or a dielectric material having a certain refractive index. For example, the cavity layer 30 may include silicon or silicon oxide. However, this is only an example, and the cavity layer 30 may include various other materials according to design conditions such as a wavelength of incident light.

The first reflector 10 and the second reflector 20 respectively provided on lower and upper surfaces of the cavity layer 30 may each be a distributed Bragg reflector (DBR).

The first reflector 10 may include one or more first material layers 11 and one or more second material layers 12. The one or more first material layers 11 and the one or more second material layers 12 may be alternately arranged. The first reflector 10 may further include one or more third material layers 13. The one or more first material layers 11, the one or more second material layers 12, and the one or more third material layers 13 may be stacked in a vertical direction (e.g., Z direction). The first reflector 10 is illustrated in a structure in which three first material layers 11 and two second material layers 12 are alternately stacked in a vertical direction on the upper surface of the third material layer 13, but this is only an example. The first reflector 10 may include only the first material layers 11 and the second material layers 12, the number and/or the arrangement order of the first material layers 11 and the second material layers 12 may be changed, and the number and/or the arrangement form of the first, second, and third material layers 11, 12, and 13 may be modified in various ways.

The first, second, and third material layers 11, 12, and 13 may include materials having different refractive indices. For example, the first material layer 11 may have a relatively highest refractive index, and the second material layer 12 may have a relatively lowest refractive index. In addition, the third material layer 13 may have a refractive index that is smaller than that of the first material layer 11 and greater than that of the second material layer 12.

For example, the first material layer 11 may include titanium oxide, and the second material layer 12 may include silicon oxide. In addition, the third material layer 13 may include hafnium oxide. This is only an example, and silicon or silicon nitride may be used as materials of the first material layer 11, the second material layer 12, and the third material layer 13.

The second reflector 20 may include one or more first material layers 21 and one or more second material layers 22. The one or more first material layers 21 and the one or more second material layers 22 may be alternately arranged. The second reflector 20 may further include one or more third material layers 23. The one or more first material layers 21, the one or more second material layers 22, and the one or more third material layers 23 may be stacked in the vertical direction (e.g., Z direction). The second reflector 20 is illustrated in a structure in which the third material layer 23 is disposed above three first material layers 21 and two second material layers 22 which are alternately stacked in the vertical direction, but this is merely an example. The second reflector 20 may include only the first material layer 21 and the second material layer 22, the number and/or the arrangement order of the first material layers 21 and the second material layers 22 may be changed, and the number and/or the arrangement form of the first, second, and third material layers 21, 22, and 23 may be modified in various ways.

Materials of the first, second, and third material layers 21, 22, and 23 of the second reflector 20 may be respectively the same as the materials of the first, second, and third material layers 11, 12, and 13 of the first reflector 10, and the first reflector 10 and the second reflector 20 may be different from each other in the number and/or arrangement form of the first, second, and third material layers. The first reflector 10 and the second reflector 20 may have independent configurations.

An etch stop layer (not shown) may be further disposed between the first reflector 10 and the cavity layer 30. The etch stop layer may be provided as needed during a patterning process for forming the cavity layer 30, and may include a material having a lower etch selectivity than the material of the cavity layer 30. The etch stop layer may be, for example, hafnium oxide, but is not limited thereto.

The first resonance structure 101 may have a first resonance wavelength. The first resonance wavelength may be determined according to an effective refractive index and a thickness L1 of the cavity layer 30, and a full width at half maximum (FWHM) of a transmission spectrum of the first resonance structure 101 may be adjusted according to detailed configurations of the first reflector 10 and the second reflector 20.

As described above, the first resonance wavelength of the first resonance structure 101 is with respect to vertically incident light. By using a plurality of first beam steering regions BS11, BS12, and BS13 disposed to respectively face a plurality of first resonator regions RC1, light is incident at different incidence angles according to positions of the first resonator regions RC1, and the plurality of first resonator regions RC1 exhibit different transmission wavelength bands.

Each of the first beam steering regions BS11, BS12, and BS13 includes the plurality of nanostructures NS, and arrangement rules of the nanostructures NS are set such that the first beam steering regions BS11, BS12, and BS13 deflect and emit incident light at different angles.

The nanostructures NS included in each of the first beam steering regions BS11, BS12, and BS13 may have a shape dimension corresponding to a sub-wavelength. Here, the sub-wavelength refers to a wavelength less than a wavelength band of light to be deflected (that is, light incident on and deflected by the first beam steering regions BS11, BS12, and BS13). The nanostructure NS may have a dimension smaller than the smallest wavelength of the wavelength band of incident light. For example, the nanostructure NS may have a cylindrical shape with a cross-sectional diameter of the sub-wavelength. However, a shape of the nanostructure NS is not limited thereto and may be, for example, in a shape of an elliptical column or a polygonal column. When the incident light is visible light, a width of the nanostructure NS may have a dimension smaller than, for example, 400 nm, 300 nm, or 200 nm.

The nanostructure NS may include a material with a higher refractive index than that of a surrounding material. For example, the nanostructure NS may include c-Si, p-Si, a-Si, an III-V compound semiconductor (GaP, GaN, GaAs, etc.), SiC, TiO2, SiN, and/or any combination thereof. The nanostructure NS having a refractive index difference from the surrounding material and the shape dimension corresponding to the sub-wavelength may change a phase of light passing through the nanostructure NS. A degree to which the phase changes is determined by detailed shape dimensions and an arrangement form of the nanostructures NS. The arrangement rule of the nanostructures NS disposed in each of the first beam steering regions BS11, BS12, and BS13 may be determined such that a phase distribution appropriate for a beam steering angle to be implemented by each of the first beam steering regions BS11, BS12, and BS13 is formed.

A dielectric material having a lower refractive index than that of the nanostructure NS may be disposed between the nanostructures NS. For example, the surrounding material may include $SiO_2$ or air. This surrounding material may be formed in the form of a protective layer (not shown) filling between the nanostructures NS and entirely covering the nanostructures NS.

A buffer layer BU may be further disposed between the first resonance structure 101 and the meta device 501. The buffer layer BU may support the plurality of nanostructures NS and may include a material with a refractive index lower than that of the nanostructure NS.

The first beam steering region BS11 and the first resonator region RC1 may form the first unit filter F1, the first beam steering region BS12 and the first resonator region RC1 may form the second unit filter F2, and the first beam steering region BS13 and the first resonator region RC1 may form the third unit filter F3.

The transmission wavelengths λ1, λ2, and λ3 of the first to third unit filters F1, F2, and F3 may correspond to the first resonance wavelength (that is, the resonance wavelength of the first resonance structure 101) or less. Each of λ1, λ2, and λ3 may be the first resonance wavelength or less, and may approximately reach 70 %, 50 % or 30 % of the first resonance wavelength. As the deflection angle by the first beam steering region BS11, BS12, and BS13 increases, that is, as the deflection angle moves away from 0 degree toward 90 degrees, λ1, λ2, and λ3 may indicate smaller wavelengths that become more deviated from the first resonance wavelength. In other words, transmission wavelengths λ1, λ2, and λ3 may have a relationship of λ1 < λ2 < λ3.

The transmission wavelengths λ1, λ2, and λ3 of the first to third unit filters F1, F2, and F3 are implemented by adjusting the incidence angles θ1, θ2, and θ3 at which light is incident on the first resonance structure 101 having the resonance wavelength $\lambda_R$.

For example, λ1, λ2, and λ3 may be expressed as follows.

$$\lambda 1 = \lambda_R * \cos\theta 1$$

$$\lambda 2 = \lambda_R * \cos\theta 2$$

$$\lambda 3 = \lambda_R * \cos\theta 3$$

The first resonance structure 101 may be designed to generate a resonance wavelength that is sensitive to the incidence angle. A thickness of the first resonance structure 101 may be greater than, for example, $\lambda_R/(2ne)$, assuming that an effective refractive index of the cavity layer 30 is ne. However, the disclosure is not limited thereto.

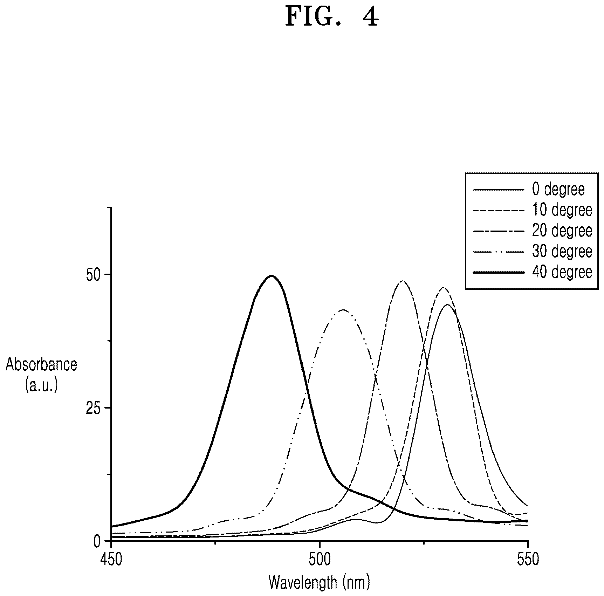

FIG. 4 is a graph showing a transmission spectrum according to the first resonance structure 101 provided in the spectral filter 1001 of FIG. 3 at various incidence angles.

It may be seen that as an angle at which light is incident on the first resonance structure 101 increases from 0 degree to about 40 degrees, a center wavelength of a transmission wavelength band decreases.

In other words, it may be seen that various different types of transmission wavelength bands may be formed by providing a meta device that deflects vertically incident light differently according to regions.

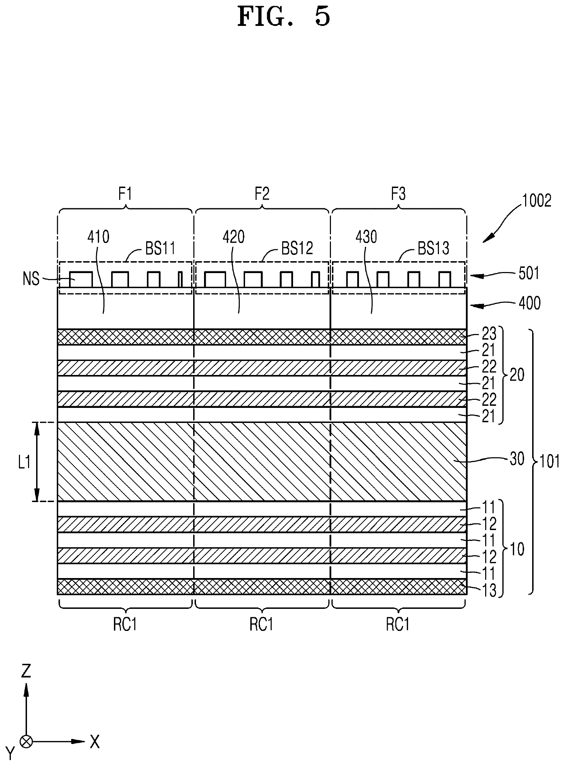

FIG. 5 is a cross-sectional view showing a schematic structure of a spectral filter 1002 according to an example embodiment.

The spectral filter 1002 of the example embodiment may be substantially the same as the spectral filter 1001 of FIG. 3, except that a band pass filter array 400 is disposed at a position of the buffer layer BU provided in the spectral filter 1001 of FIG. 3.

The band pass filter array 400 may include a first filter 410, a second filter 420, and a third filter 430. The first filter 410 may be a band pass filter of which transmission wavelength band includes a transmission wavelength band exhibited by the first unit filter F1 and wider than the transmission wavelength band of the first unit filter F1. Each of the second filter 420 and the third filter 430 may be also a band pass filter including a transmission wavelength band exhibited by each of the second filter F2 and the third filter F3 and having a transmission wavelength band wider than the corresponding transmission wavelength band. The first filter 410, the second filter 420, and the third filter 430 may be provided to supplement filtering performances of the first unit filter F1, the second unit filter F2, and the third unit filter F3, respectively. The first filter 410, the second filter 420, and the third filter 430 may be, for example, a blue filter, a green filter, and a red filter, respectively, but are not limited thereto.

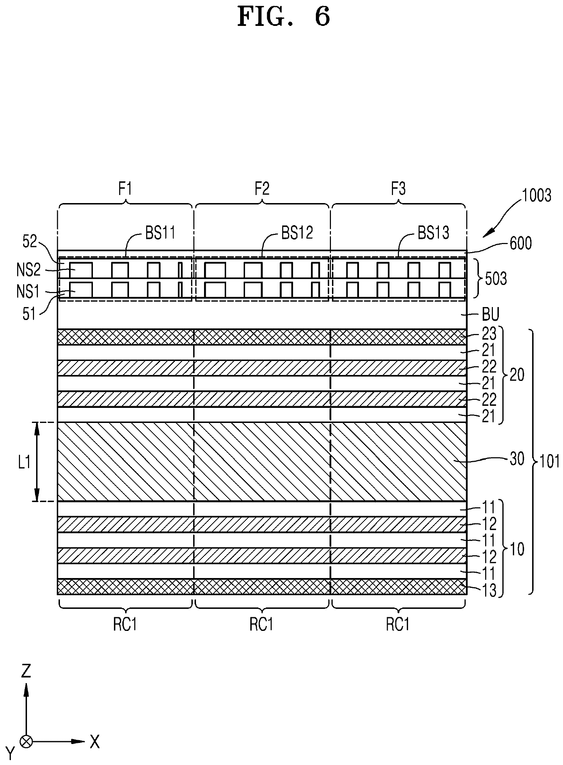

FIG. 6 is a cross-sectional view showing a schematic structure of a spectral filter 1003 according to an example embodiment.

The spectral filter 1003 of this embodiment may be substantially the same as the spectral filter 1001 of FIG. 3, except that first nanostructures NS1 and second nanostructures NS2 forming a meta device 503 are arranged to form different layers.

A first protective layer 51 is formed to entirely cover the first nanostructures NS1, and the second nanostructures NS2 are formed on the first protective layer 51. A second protective layer 52 may be formed to entirely cover the second nanostructures NS2. Each of the first protective layer 51 and the second protective layer 52 may include a material with a lower refractive index than the refractive index of each of the first nanostructure NS1 and the second nanostructure NS2.

An antireflective layer 600 may be further disposed on the second protective layer 52.

As in the example embodiment, the meta device 503 may be configured by using the first nanostructures NS1 and the second nanostructures NS2 arranged in a two-layer structure in consideration of beam steering performance to be exhibited by each of the first beam steering regions BS11, BS12, and BS13. For example, when a great aspect ratio is required for the shape dimension of a nanostructure, a manufacturing process of the meta device may be difficult, and forming the first nanostructure NS1 and the second nanostructure NS2 may be performed by forming a first layer of the first nanostructures NS1 and forming a second layer of the second nanostructures NS2. Alternatively, for other design reasons, the first nanostructures NS1 and the second nanostructures NS2 may be arranged in a multi-layer structure. In multiple layers shown in the drawing, arrangement rules of the first nanostructures NS1 and the second nanostructures NS2 are shown to be the same in the first layer and the second layer, but this is an example and is not limited thereto.

The configurations of a two-layer (or any other multi-layer) nanostructure arrangement, the first and second protective layers 51 and 52 covering the first and second nanostructures NS1 and NS2, and the antireflective layer 600 described in the above embodiment are omitted from the description of the following embodiment for convenience of explanation, but may also be applied to any of the following embodiment(s).

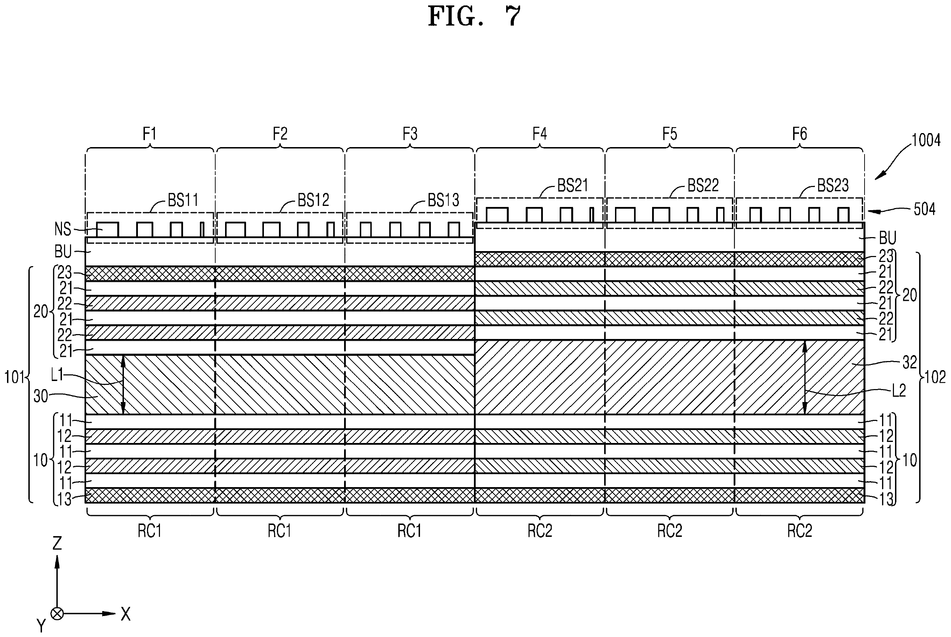

FIG. 7 is a cross-sectional view showing a schematic structure of a spectral filter 1004 according to an example embodiment.

The spectral filter 1004 of the example embodiment includes the first resonance structure 101 designed to have a first resonance wavelength and a second resonance structure 102 designed to have a second resonance wavelength that is different from the first resonance wavelength. The first resonance structure 101 is divided into the plurality of first resonator regions RC1, and the second resonance structure 102 is divided into a plurality of second resonator regions RC2. The first resonance structure 101 and the second resonance structure 102 have similar configurations, but the thickness L1 of the cavity layer 30 of the first resonance structure 101 and a thickness L2 of a cavity layer 32 of the second resonance structure 102 may be different from each other.

A meta device 504 includes the plurality of nanostructures NS, and the plurality of nanostructures NS are arranged to form the plurality of first beam steering regions BS11, BS12, and BS13 respectively facing the plurality of first resonator regions RC1 and a plurality of second beam steering regions BS21, BS22, and BS23 respectively facing the plurality of second resonator regions RC2.

The first beam steering region BS11 and the first resonator region RC1 may form the first unit filter F1, the first beam steering region BS12 and the first resonator region RC1 may form the second unit filter F2, and the first beam steering region BS13 and the first resonator region RC1 may form the third unit filter F3.

The second beam steering region BS21 and the second resonator region RC2 may form a fourth unit filter F4, the second beam steering region BS22 and the second resonator region RC2 may form a fifth unit filter F5, and the second beam steering region BS23 and the second resonator region RC2 may form a sixth unit filter F6.

The first to sixth unit filters F1, F2, F3, F4, F5, and F6 may respectively exhibit different transmission wavelengths $\lambda 1$, $\lambda 2$, $\lambda 3$, $\lambda 4$, $\lambda 5$, and $\lambda 6$.

The first beam steering region BS11 and the second beam steering region BS21 may have the same arrangement form of the nanostructures NS. That is, the first beam steering region BS11 and the second beam steering region BS21 may respectively cause incident light to be deflected at the same angle and emitted toward the first resonator region RC1 and the second resonator region RC2 that face the first beam steering region BS11 and the second beam steering region BS21. The first resonator region RC1 and the second resonator region RC2 are designed to have different resonance wavelengths, and thus, even when the first beam steering region BS11 and the second beam steering region BS21 are configured in the same manner, the first unit filter F1 and the fourth unit filter F4 may exhibit the transmission wavelengths $\lambda 1$ and $\lambda 4$ that are different from each other. The arrangement form of the nanostructures NS in the first beam steering region BS11 and the second beam steering region BS21 is not limited to be the same, and may be adjusted differently according to the desired transmission wavelengths $\lambda 1$ and $\lambda 4$.

Similarly, the first beam steering region BS12 and the second beam steering region BS22 may have the same arrangement form of the nanostructures NS. Alternatively, the arrangement form of the nanostructures NS in the first beam steering region BS12 and the second beam steering region BS22 may be adjusted differently according to the desired transmission wavelengths $\lambda 2$ and $\lambda 5$. The first beam steering region BS13 and the second beam steering region BS23 may have the same arrangement form of the nanostructures NS. Alternatively, the arrangement form of the nanostructures NS in the first beam steering region BS13 and the second beam steering region BS23 may be adjusted differently according to the desired transmission wavelengths $\lambda 3$ and $\lambda 6$.

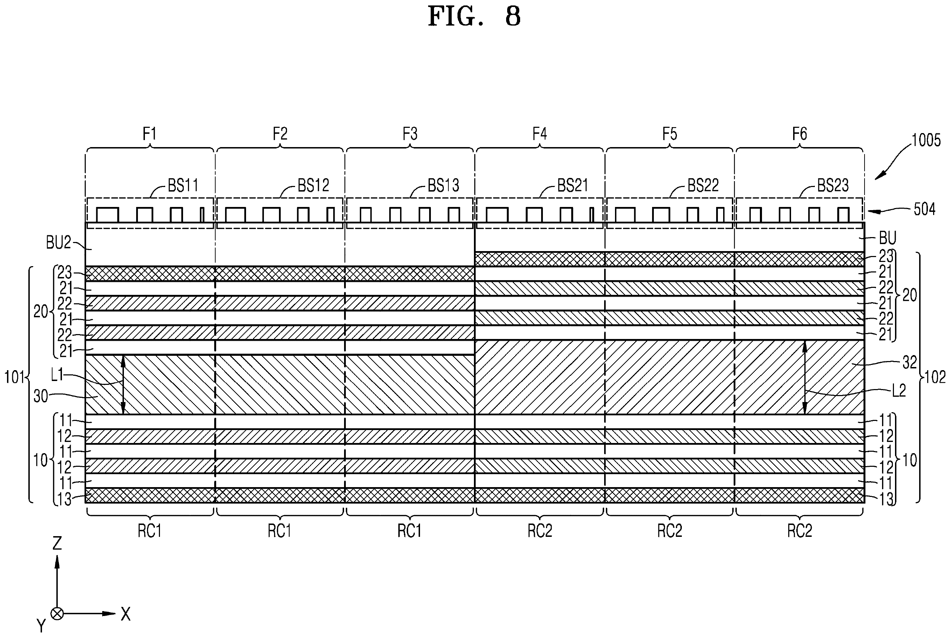

FIG. 8 is a cross-sectional view showing a schematic structure of a spectral filter 1005 according to an example embodiment.

The spectral filter 1005 of the example embodiment is different from the spectral filter 1004 in FIG. 7 in that a thickness of a buffer layer BU2 disposed on the first resonance structure 101 is different from a thickness of the buffer layer BU disposed on the second resonance structure 102.

As described above, by adjusting the thickness of the buffer layer BU2 disposed on the first resonance structure 101, the plurality of first beam steering regions BS11, BS12, and BS13 and the plurality of second beam steering regions BS21, BS22, and BS23 forming the meta device 504 may be formed at the same height, and a manufacturing process of the meta device 504 may become easier.

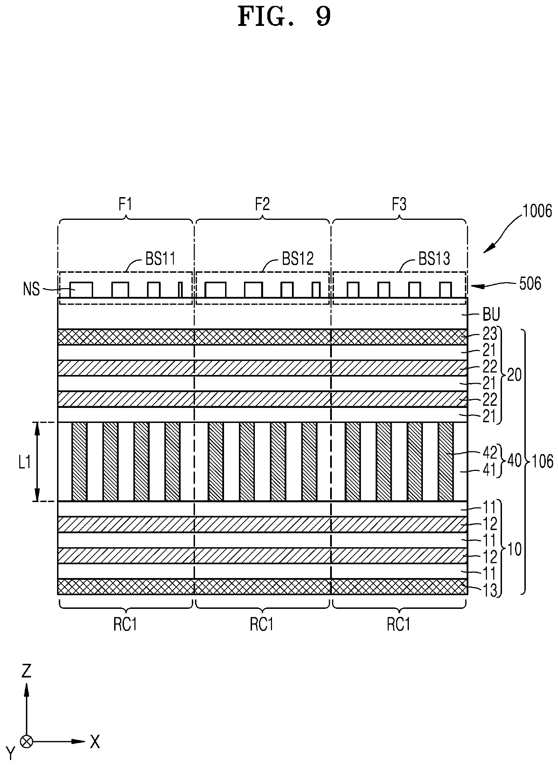

FIG. 9 is a cross-sectional view showing a schematic structure of a spectral filter 1006 according to an example embodiment.

The spectral filter 1006 includes a first resonance structure 106 and a meta device 506.

The first resonance structure 106 includes a cavity layer 40, which is different in structure from the cavity layer 30 of the spectral filter 1001 of FIG. 3.

The cavity layer 40 may have a dielectric pattern. The cavity layer 40 may have, for example, a pattern including a first dielectric 41 and a second dielectric 42 having different refractive indices. The first dielectric 41 may include, for example, silicon oxide, and the second dielectric 42 may include, for example, titanium oxide. The first dielectric 41 and the second dielectric 42 may have patterns arranged alternately in the X direction, as shown in FIG. 9. Materials, numbers of stacking, and/or widths of the first dielectric 41 and the second dielectric 42 are examples and may be appropriately adjusted so that the cavity layer 40 may exhibit a desired effective refractive index.

The meta device 506 includes the plurality of first beam steering regions BS11, BS12, and BS13, and arrangement rules of the nanostructures NS may be determined to adjust an angle of incidence light that passes through each of the plurality of first beam steering regions BS11, BS12, and BS13. The arrangement rules of the nanostructures NS may be determined in consideration of a resonance wavelength of the first resonance structure 106 and a desired transmission wavelength band with respect to each of the first to third unit filters F1, F2, and F3.

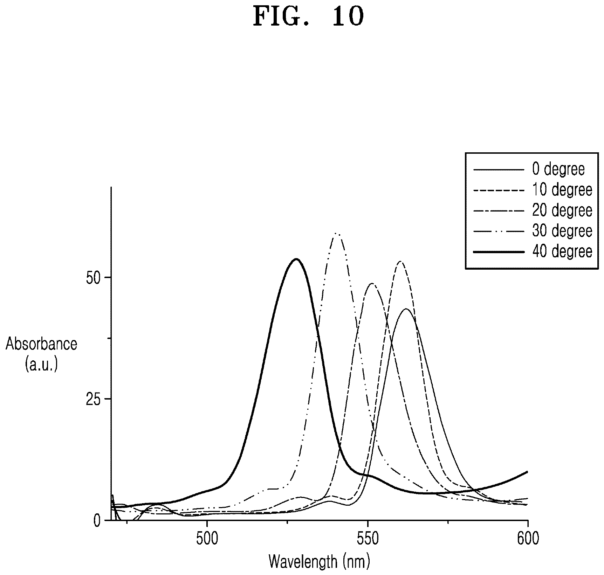

FIG. 10 is a graph showing a transmission spectrum according to the first resonance structure 106 provided in the spectral filter 1006 of FIG. 9 at various incidence angles.

It may be seen that as an angle at which light is incident on the first resonance structure 106 increases from 0 degrees to about 40 degrees, a center wavelength of a transmission wavelength band decreases.

In other words, it may be seen that various different types of transmission wavelength bands may be formed by providing a meta device that deflects vertically incident light differently according to positions of the first resonance structure 106.

In addition, it may be seen that by forming a dielectric pattern on the cavity layer 40, a transmission wavelength band different from the wavelength band appearing in the transmission spectrum of FIG. 4 may be formed.

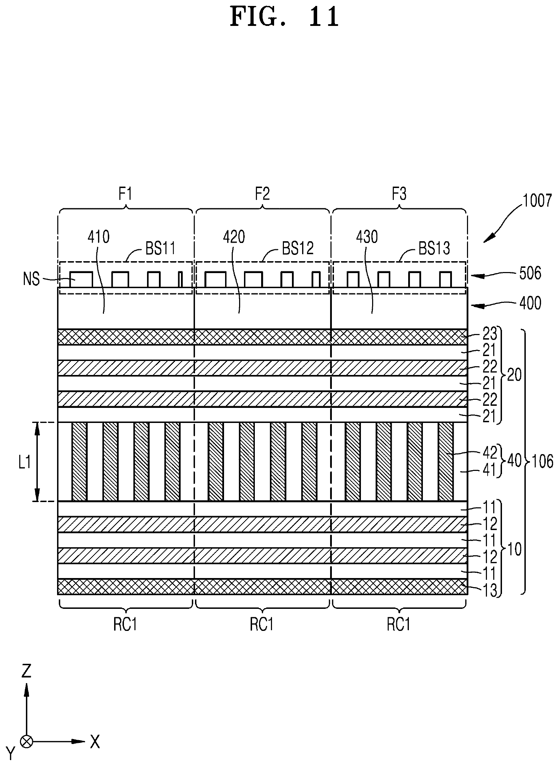

FIG. 11 is a cross-sectional view showing a schematic structure of a spectral filter 1007 according to an example embodiment.

The spectral filter 1007 of the example embodiment may be substantially the same as the spectral filter 1006 of FIG. 9, except that the band pass filter array 400 is disposed at the buffer layer BU provided in the spectral filter 1006 of FIG. 9.

The band pass filter array 400 may include the first filter 410, the second filter 420, and the third filter 430. The first filter 410 may be a band pass filter of which transmission wavelength band includes a wavelength band exhibited by the first unit filter F1 and wider than the transmission wavelength band of the first unit filter F1. Each of the second filter 420 and the third filter 430 may be also a band pass filter, each having a transmission wavelength band including and wider than a transmission wavelength band of the second filter F2 and a transmission wavelength band of the third filter F3, respectively. The first filter 410, the second filter 420, and the third filter 430 may be provided to supplement filtering performances of the first unit filter F1, the second unit filter F2, and the third unit filter F3, respectively. The first filter 410, the second filter 420, and the third filter 430 may be, for example, a blue filter, a green filter, and a red filter, respectively, but are not limited thereto.

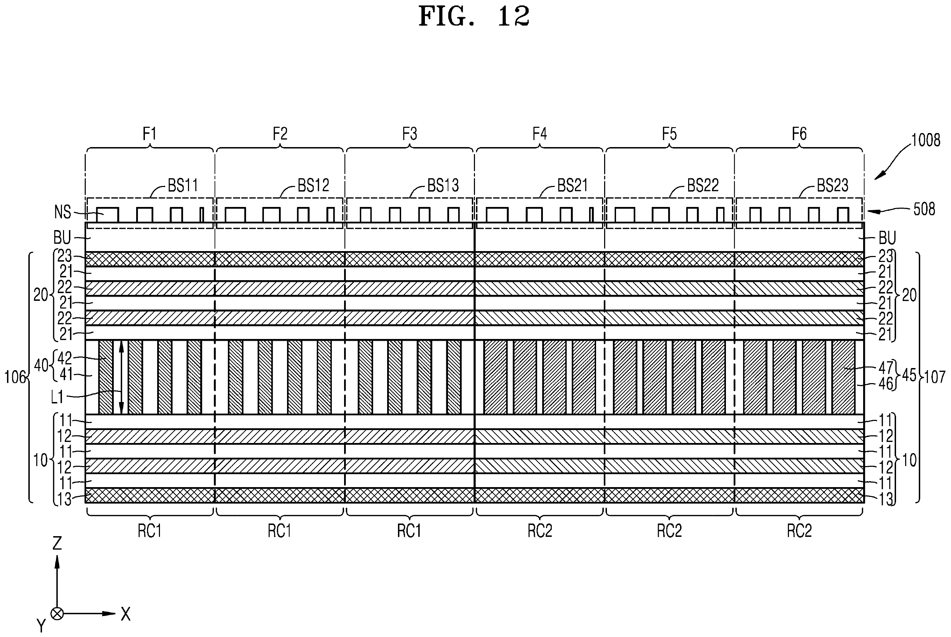

FIG. 12 is a cross-sectional view showing a schematic structure of a spectral filter 1008 according to an example embodiment.

The spectral filter 1008 of the example embodiment includes the first resonance structure 106 designed to have a first resonance wavelength, and a second resonance structure 107 designed to have a second resonance wavelength that is different from the first resonance wavelength. The first resonance structure 106 is divided into the plurality of first resonator regions RC1, and the second resonance structure 107 is divided into the plurality of second resonator regions RC2.

A meta device 508 includes the first beam steering regions BS11, BS12, and BS13 respectively facing the plurality of first resonator regions RC1 and the second beam steering regions BS21, BS22, and BS23 respectively facing the plurality of second resonator regions RC2.

The first resonance structure 106 and the second resonance structure 107 have similar configurations, but the cavity layer 40 of the first resonance structure 106 and a cavity layer 45 of the second resonance structure 107 have different dielectric patterns.

The cavity layer 40 of the first resonance structure 106 has a dielectric pattern including a first dielectric 41 and a second dielectric 42, and the cavity layer 45 of the second resonance structure 107 has a dielectric pattern including a third dielectric 46 and a fourth dielectric 47. The third dielectric 46 and the fourth dielectric 47 may include the same materials as the first dielectric 41 and the second dielectric 42, respectively, and have different widths in the X direction from the first dielectric 41 and the second dielectric 42, respectively. Accordingly, the cavity layer 40 of the first resonance structure 106 and the cavity layer 45 of the second resonance structure 107 may have different effective refractive indices.

The spectral filter 1008 of such a structure may form the first resonance structure 106 of the first resonance wavelength, and the second resonance structure 107 of the second resonance wavelength by including the cavity layers 40 and 45 having the same thickness, and thus, a manufacturing process may become easier.

The spectral filter 1008 may implement the first to sixth unit filters F1, F2, F3, F4, F5, and F6 by utilizing two types of the first and second resonance structures 106 and 107 and the meta device 508.

Similarly to the spectral filter 1004 of FIG. 7, the first beam steering region BS11 and the second beam steering region BS21 may have the same arrangement form of the nanostructures NS. However, this is an example, and arrangement form of the nanostructures NS in the first beam steering region BS11 and the second beam steering region BS21 is not limited to be the same, and may be adjusted differently according to a desired transmission wavelength band.

Similarly, the first beam steering region BS12 and the second beam steering region BS22 may have the same arrangement form of the nanostructures NS. Alternatively, the arrangement form of the nanostructures NS may be adjusted differently according to transmission wavelength bands to be implemented by the second unit filter F2 and the fifth unit filter F5. The first beam steering region BS13 and the second beam steering region BS23 may have the same arrangement form of the nanostructures NS. Alternatively, the arrangement form of the nanostructures NS may be adjusted differently according to transmission wavelength bands to be implemented by the third unit filter F3 and the sixth unit filter F6.

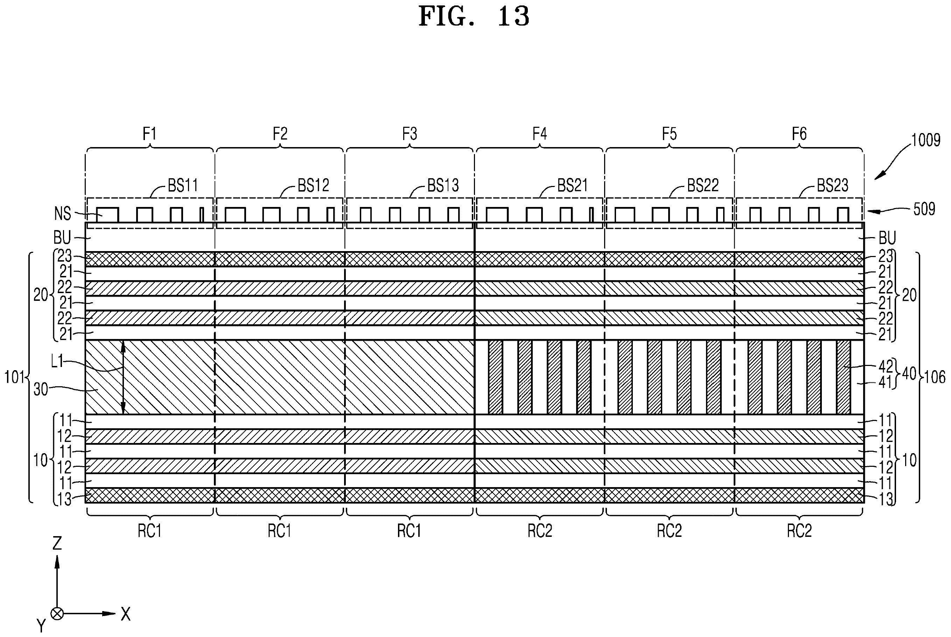

FIG. 13 is a cross-sectional view showing a schematic structure of a spectral filter 1009 according to an example embodiment.

The spectral filter 1009 of the example embodiment includes the first resonance structure 101 provided in the spectral filter 1001 illustrated in FIG. 3, and the first resonance structure 106 provided in the spectral filter 1006 illustrated in FIG. 9, as a second resonance structure 106.

The cavity layer 30 of the first resonance structure 101 and the cavity layer 40 of the second resonance structure 106 may be set to have the same thickness.

A meta device 509 includes the first beam steering regions BS11, BS12, and BS13 respectively facing the plurality of first resonator regions RC1 and the second beam steering regions BS21, BS22, and BS23 respectively facing the plurality of second resonator regions RC2.

The spectral filter 1009 may implement the first to sixth unit filters F1, F2, F3, F4, F5, and F6 by utilizing two types of resonance structures, i.e., the first resonance structure 101 and the second resonance structure 106, and the meta device 509.

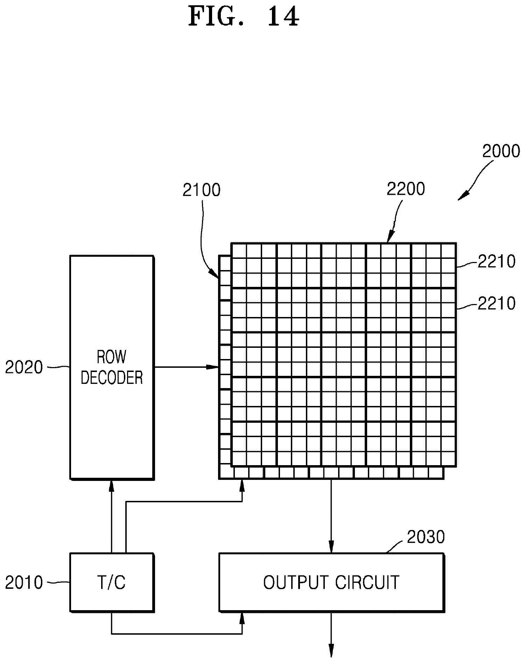

FIG. 14 is a block diagram of an image sensor according to an example embodiment.

Referring to FIG. 14, an image sensor 2000 may include a spectral filter array 2200, a pixel array provided on a sensor substrate 2100, a timing controller 2010, a row decoder 2020, and an output circuit 2030. A plurality of light sensing cells provided on the sensor substrate 2100 includes a light detection element that senses light and generates an electrical signal. The light detection element may include, but is not limited to, a photo diode, a charge coupled device (CCD), or a complementary metal oxide semiconductor (CMOS) sensor.

The spectral filter array 2200 may include a plurality of spectral filters 2210 which are two-dimensionally arranged. The spectral filters 2210 include a plurality of unit filters F1, F2, and F3 having different transmission wavelength bands. The spectral filter 2210 may be one of the spectral filters 1000 to 1009 mentioned in the above-described embodiments, or a combination or modified form thereof.

The plurality of light sensing cells provided on the sensor substrate 2100 operate as a plurality of pixels that sense light that has passed through the plurality of unit filters provided in the spectral filter array 2200, and the plurality of pixels may be arranged two-dimensionally along a plurality of rows and columns to face the plurality of unit filters. The row decoder 2020 selects one of the rows of the sensor substrate 2100 in response to a row address signal output from the timing controller 2010. The output circuit 2030 outputs a light sensing signal in column units from the plurality of pixels arranged along the selected row. To this end, the output circuit 2030 may include a column decoder and an analog to digital converter (ADC). For example, the output circuit 2030 may include a plurality of ADCs disposed for each column between the column decoder and the sensor substrate 2100, or one ADC disposed at an output terminal of the column decoder. The timing controller 2010, the row decoder 2020, and the output circuit 2030 may be implemented as one chip or as separate chips. A processor that processes san image signal output through the output circuit 2030 may be implemented as a single chip along with the timing controller 2010, the row decoder 2020, and the output circuit 2030.

The image sensor 2000 may be a multispectral image (MSI) sensor. The MSI sensor may sense light of various wavelength bands, different from general RGB image sensors, or including an RGB wavelength. The MSI sensor may sense light of more types of wavelength bands by having more channels (e.g., unit filters).

The plurality of spectral filters 2210 included in the spectral filter array 2200 are similar in that all the plurality of spectral filters 2210 each include a plurality of unit filters F1, F2, and F3? with different transmission wavelength bands, but detailed structures of unit filters having the same transmission wavelength band, for example, the two unit filters F1 having the transmission wavelength of λ1, may differ from each other according to a relative position of the spectral filter 2210 including the unit filter F1 within the image sensor 2000.

For example, a nanostructure arrangement of a meta device of the spectral filter 2210 located at a center region of the image sensor 2000 among the plurality of spectral filters 2210 and a nanostructure arrangement of a meta device of the spectral filter 2210 located at a periphery of the image sensor 2000 may be different from each other.

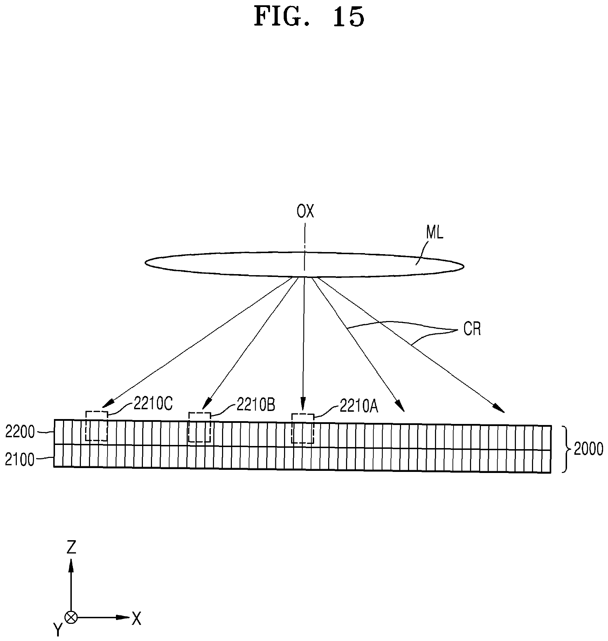

An example embodiment may employ this configuration considering that an incidence angle of light incident on the spectral filter array 2200 may vary depending on the relative position on the image sensor 2000. This is described in more below with reference to FIGS. 15 to 18.

FIG. 15 is a conceptual diagram explaining a chief ray angle (CRA) of light incident on the image sensor 2000 according to an example embodiment.

The image sensor 2000 may be employed in a camera module along with a module lens ML, and light directed to the image sensor 2000 through the module lens ML may have different incidence angles depending on a relative position on the image sensor 2000. The incidence angle of light incident on the image sensor 2000 may be defined as a chief ray angle, CRA. A chief ray, CR refers to a ray that starts from a point on a subject, passes through the center of the module lens ML, and is incident on a pixel array 2100. The CRA refers to an angle formed by the CR with an optical axis OX.

A CRA of light incident on the center of the spectral filter array 2200 is 0 degree, and the CRA of the incident light increases toward an edge of the spectral filter array 2200. As shown, a CRA of light incident on a spectral filter 2210A located at the center of the spectral filter array 2200 is 0 degree, a CRA of light incident on a spectral filter 2210B located outside the center is $\theta_B$, and a CRA of light incident on a spectral filter 2210C located further away from the center is $\theta_C$, which is greater than $\theta_B$. As described above, according to the CRA, detailed structures of unit filters having the same transmission wavelength band provided in each of the spectral filters 2210A, 2210B, and 2210C may be different from each other.

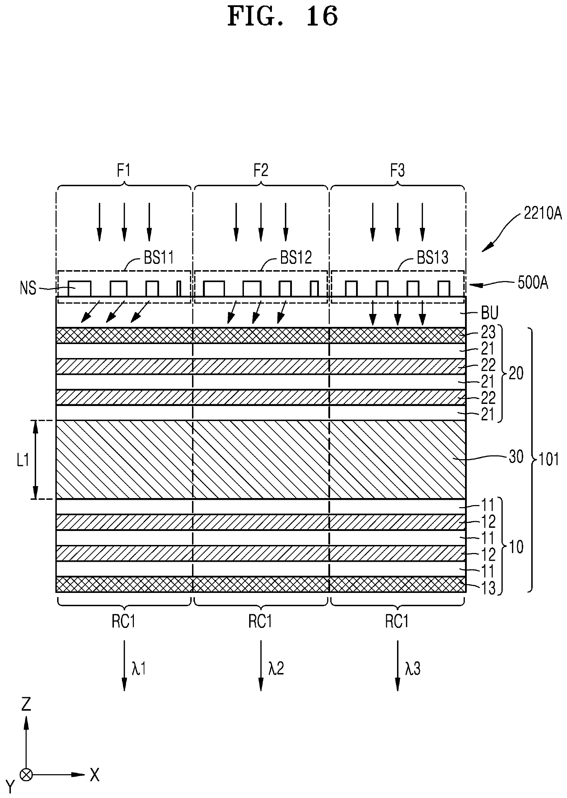

FIGS. 16 to 18 are cross-sectional views showing structures of the spectral filters 2210A, 2210B, and 2210C at a plurality of positions having different CRAs in the image sensor 2000 according to an example embodiment.

FIG. 16 shows a structure of the spectral filter 2210A located at the center of the spectral filter array 2200, that is, at a position where a CRA is 0 degree.

A meta device 500A includes the plurality of first beam steering regions BS11, BS12, and BS13. The nanostructures NS of the first beam steering region BS11 are arranged according to an arrangement rule that deflects vertically incident light to a certain angle, for example, θ1. The nanostructures NS of the first beam steering region BS12 are arranged according to an arrangement rule that deflects the vertically incident light at an angle θ2 that is smaller than the deflection angle θ1 by the first beam steering region BS11. The nanostructures NS of the first beam steering region BS13 are arranged so that incident light is emitted without changing the angle of the incidence angle. That is, the CRA of 0 degree is maintained even after light passes through the first beam steering region BS13, and light is incident on the first resonator region RC1.

The first resonator region RC1 and the first beam steering region BS11 operate as the first unit filter F1 that exhibits the transmission wavelength λ1, the first resonator region RC1 and the first beam steering region BS12 operate as second unit filter F2 that exhibits the transmission wavelength λ2, and the first resonator region RC1 and the first beam steering region BS13 operate as the third unit filter F3 that exhibits the transmission wavelength λ3.

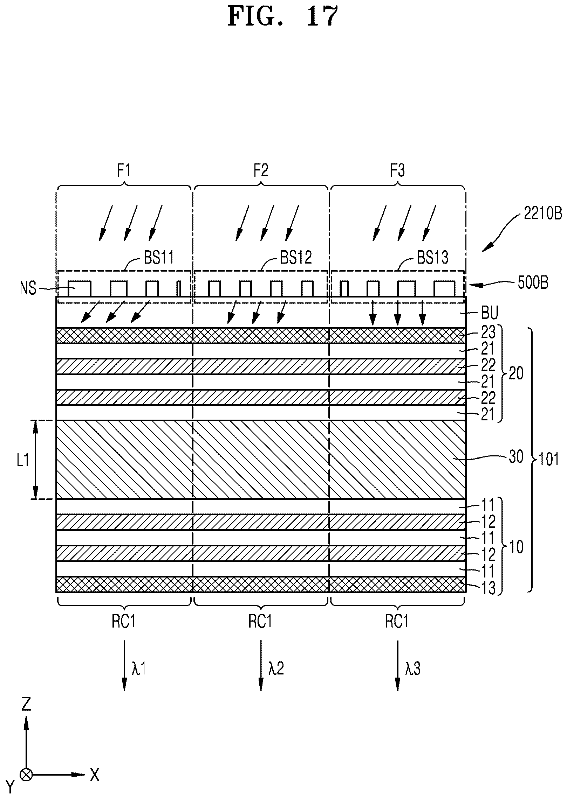

Referring to FIG. 17, a detailed configuration of a meta device 500B of the spectral filter 2210B at a position where the CRA is $\theta_B$ greater than 0 degree is different from that of the meta device 500A of the spectral filter 2210A of FIG. 16.

In other words, the detailed configuration of the meta device 500B, e.g., an arrangement rule of the nanostructures NS, of the spectral filter 2210B at the position where the CRA is $\theta_B$ greater than 0 degree may be different from that of the meta device 500A of the spectral filter 2210A, to implement the first unit filter F1 indicating the same transmission wavelength band as the first unit filter F1 of the spectral filter 2210A at the position where the CRA is 0 degree, implement the second unit filter F2 indicating the same transmission wavelength band as the second unit filter F2 of the spectral filter 2210A, and implement the third unit filter F3 indicating the same transmission wavelength band as the third unit filter F3 of the spectral filter 2210A.

The meta device 500B includes the plurality of first beam steering regions BS11, BS12, and BS13. The nanostructures NS of the first beam steering region BS11 are arranged according to an arrangement rule that deflects light incident at an angle greater than 0 degree, for example, $\theta_B$, to the angle θ1 greater than the angle $\theta_B$. The nanostructures NS of the first beam steering region BS11 are arranged in the X direction, in the order of a decreasing width (i.e., highest to lowest), but the specific size shown is only an example.

The nanostructures NS of the first beam steering region BS12 are arranged so that light incident at an angle greater than 0 degree, for example, the angle $\theta_B$, is emitted at the angle θ2 and incident on the first resonator region RC1. In the drawing, assuming that $\theta_B$ is equal to θ2, the nanostructures NS of the first beam steering region BS12 are arranged so that incident light is not deflected.

The nanostructures NS of the first beam steering region BS13 are arranged so that light incident at the

angle $\theta_B$ is deflected and emitted at an angle smaller than the angle $\theta_B$, for example, an angle of 0 degree. Contrary to the first beam steering region BS11, the nanostructures NS of the first beam steering region BS13 are arranged in the X direction, in the order of an increasing width (i.e., lowest to highest), but the specific size shown is only an example.

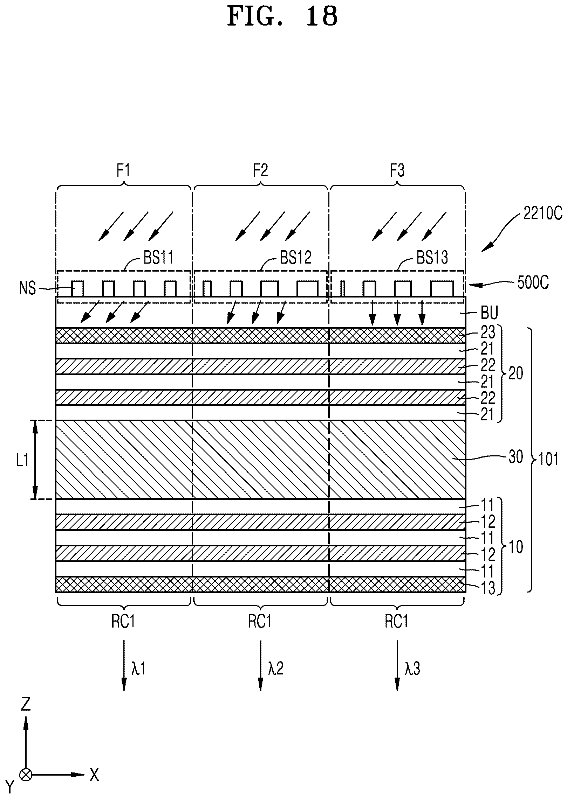

Referring to FIG. 18, a detailed configuration of a meta device 500C of the spectral filter 221 0C at a position where the CRA is $\theta_C$ greater than 0 degree and greater than $\theta_B$ is different from those of the meta device 500A of the spectral filter 2210A of FIG. 16 and the meta device 500B of the spectral filter 2210B of FIG. 17.

In other words, the detailed configuration of the meta device 500C, e.g., an arrangement rule of the nanostructures NS, of the spectral filter 2210C at the position where the CRA is $\theta_C$ greater than 0 degree and greater than $\theta_B$ may be different from those of the meta device 500A of the spectral filter 221 0A and the meta device 500B of the spectral filter 221 0B, to implement the first unit filter F1 exhibiting the same transmission wavelength band as the first unit filter F1 of the spectral filter 2210A at the position where the CRA is 0 degree and the first unit filter F1 of the spectral filter 2210B at the position where the CRA is $\theta_B$, implement the second unit filter F2 exhibiting the same transmission wavelength band as the second unit filter F2 of the spectral filter 2210A and the second unit filter F2 of the spectral filter 2210B, and implement the third unit filter F3 exhibiting the same transmission wavelength band as the third unit filter F3 of the spectral filter 221 0A and the third unit filter F3 of the spectral filter 2210B.

The meta device 500C includes the plurality of first beam steering regions BS11, BS12, and BS13. The nanostructures NS of the first beam steering region BS11 are arranged so that light incident at the angle $\theta_C$ is emitted at the angle $\theta_1$ and incident on the first resonator region RC1. In the drawing, assuming that $\theta_C$ is equal to $\theta1$, that is, the nanostructures NS in the first beam steering region BS11 are arranged so that incident light is not deflected.

The nanostructures NS of the first beam steering region BS12 are arranged so that light incident at an angle greater than 0 degree, for example, the angle $\theta_C$, is emitted at the angle $\theta2$, which is smaller than the angle $\theta_C$, and emitted toward the first resonator region RC1. The nanostructures NS may be arranged in the X direction in order of an increasing width (i.e., lowest to highest).

The nanostructures NS of the first beam steering region BS13 are arranged so that light incident at the angle $\theta_C$ is deflected and emitted at an angle smaller than the angle $\theta_C$, for example, the angle of 0 degree. Similar to the first beam steering region BS12, the nanostructures NS of the first beam steering region BS13 are arranged in the X direction in order of an increasing width, and has an inclination of an increasing width greater than that of the first beam steering region BS12.

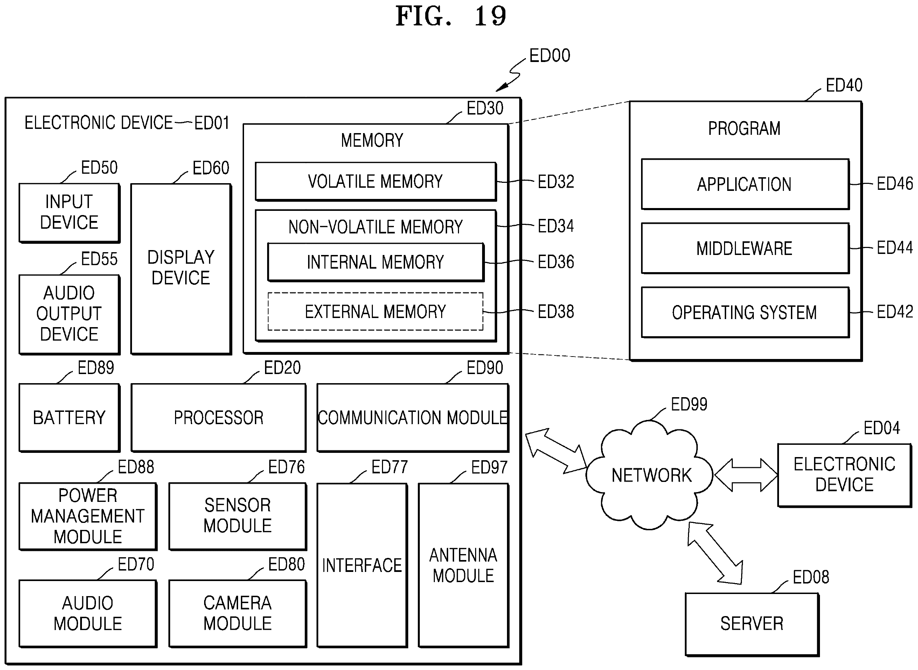

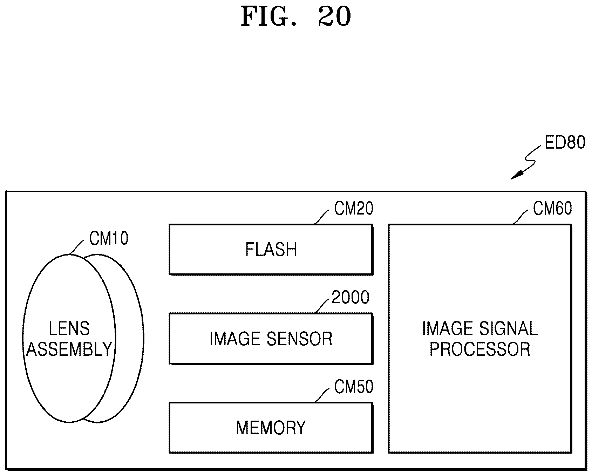

FIG. 19 is a block diagram schematically showing an electronic device ED01 according to an example embodiment. FIG. 20 is a block diagram schematically showing a camera module ED80 provided in the electronic device ED01 of FIG. 19.

Referring to FIG. 19, in a network environment ED00, the electronic device ED01 may communicate with another electronic device ED04 or communicate with a server ED08. The electronic device ED01 may include a processor ED20, a memory ED30, an input device ED50, an audio output device ED55, a display device ED60, an audio module ED70, a sensor module ED76, an interface ED77, a haptic module (not shown), a camera module ED80, a power management module ED88, a battery ED89, a communication module ED90, and/or an antenna module ED97. In the electronic device ED01, some (e.g., the display device ED60, etc.) of constituent elements may be omitted or other constituent elements may be added. Some of the constituent elements may be implemented by one integrated circuit. For example, the sensor module ED76 (e.g., a fingerprint sensor, an iris sensor, an illuminance sensor, etc.) may be implemented by being embedded in the display device ED60 (e.g., a display, etc.) Furthermore, when the image sensor 2000 includes a spectral function, some functions (e.g., functions of a color sensor and an illuminance sensor) of the sensor module ED76 may be implemented by the image sensor 2000, not by a separate sensor module.

The processor ED20 may control one or a plurality of other constituent elements (e.g., hardware and software constituent elements, etc.) of the electronic device ED01 connected to the processor ED20 by executing software (e.g., a program ED40, etc.), and perform various data processing or calculations. As part of the data processing or calculations, the processor ED20 may load, in a volatile memory ED32, commands and/or data received from other constituent elements (e.g., the sensor module ED76, the communication module ED90, etc.), process the command and/or data stored in the volatile memory ED32, and store result data in a non-volatile memory ED34.

The memory ED30 may store various data to be used in the constituent elements (e.g., the processor ED20, the sensor module ED76, etc.) of the electronic device ED01. The data may include, for example, software (e.g., the program ED40, etc.) and input data and/or output data about commands related thereto. The memory ED30 may include the volatile memory ED32 and/or the non-volatile memory ED34. The non-volatile memory ED34 may include an internal memory ED36 fixedly installed in the electronic device ED01 and an external memory ED38 that is removable.

The program ED40 may be stored in the memory ED30 as software, and may include an operating system ED42, middleware ED44, and/or an application ED46. The camera module ED80 may capture a still image and a video. The camera module ED80 may include a lens assembly including one or a plurality of lenses, the image sensor 2000, image signal processors, and/or flashes. The lens assembly included in the camera module ED80 may collect light emitted from a subject for image capturing.

Referring to FIG. 20, the camera module ED80 may include a lens assembly CM10, a flash CM20, the image sensor 2000 (e.g., the image sensor 2000 of FIG. 14, etc.), a memory CM50 (e.g., a buffer memory, etc.), and/or an image signal processor CM60. The lens assembly CM10 may collect light emitted from a subject for image capturing. The camera module ED80 may include a plurality of lens assemblies CM10, and in this case, the camera module ED80 may include a dual camera, a 360 degrees camera, or a spherical camera. Some of the lens assemblies CM10 may have the same lens attributes (e.g., a viewing angle, a focal length, auto focus, F Number, optical zoom, etc.), or different lens attributes. The lens assembly CM10 may include a wide angle lens or a telescopic lens. A dual or multi-camera module may have a combination of different attributes of a filter array.

The flash CM20 may emit light used to reinforce light emitted or reflected from a subject. The flash CM20 may include one or a plurality of light-emitting diodes (e.g., a red-green-blue (RGB) LED, a white LED, an infrared LED, an ultraviolet LED, etc.), and/or a xenon lamp. The image sensor 2000 may include the image sensor of FIG. 14, and convert light emitted or reflected from the subject and transmitted through the lens assembly CM10 into electrical signals, thereby obtaining an image corresponding to the subject. The image sensor 2000 may include one or a plurality of sensors selected from image sensors having different attributes such as an RGB sensor, a black and white (BW) sensor, an IR sensor, or UV sensor. Each sensor included in the image sensor 2000 may be implemented by a charged coupled device (CCD) sensor and/or a complementary metal oxide semiconductor (CMOS) sensor.

The memory CM50 may store a part or entire data of an image obtained through the image sensor 2000 for a subsequent image processing operation. For example, when a plurality of images are obtained at high speed, only low resolution images are displayed while the obtained original data (e.g., Bayer-patterned data, high resolution data, etc.) is stored in the memory CM50. Then, the memory CM50 may be used to transmit the original data of a selected (e.g., via user selection, etc.) image to the image signal processor CM60. The memory CM50 may be incorporated into the memory ED30 of the electronic device ED01, or configured to be an independently operated separate memory.

The image signal processor CM60 may perform image processing on the image obtained through the image sensor 2000 or the image data stored in the memory CM50. The image processing may include, for example, depth map generation, three-dimensional modeling, panorama generation, feature point extraction, image synthesis, and/or image compensation (e.g., noise reduction, resolution adjustment, brightness adjustment, blurring, sharpening, softening, etc.) The image signal processor CM60 may perform control (e.g., exposure time control, or read-out timing control, etc.) on constituent elements (e.g., the image sensor 2000, etc.) included in the camera module ED80. The image processed by the image signal processor CM60 may be stored again in the memory CM50 for additional processing or provided to external constituent elements (e.g., the memory ED30, the display device ED60, the electronic device ED04, the server ED08, etc.) of the camera module ED80. The image signal processor CM60 may be incorporated into the processor ED20, or configured to be a separate processor operated independently of the processor ED20. When the image signal processor CM60 is configured as a separate processor from the processor ED20, the image processed by the image signal processor CM60 may undergo additional image processing by the processor ED20 and then displayed through the display device ED60.

Referring back to FIG. 19, the electronic device ED01 may include a plurality of camera modules ED80 having different attributes or functions. In this case, one of the camera modules ED80 may be a wide angle camera, and another one of the camera modules ED80 may be a telescopic camera. Similarly, one of the camera modules ED80 may be a front side camera, and another one of the camera modules ED80 may be a read side camera. In addition, the camera module ED80 may be a combined camera module in which an image sensor including an existing RGB three-color filter and a spectral image sensor including a spectral filter are combined and data of the combined two image sensors is integrated and processed.

The image sensor 2000 according to some example embodiments may be applied to various electronic devices.

The image sensor 2000 according to some example embodiments may be applied to a mobile phone or smartphone, a tablet or smart tablet, a digital camera or camcorder, a notebook computer, a television or a smart television, etc. For example, the smartphone or the smart tablet may include a plurality of high resolution cameras, each having a high resolution image sensor mounted thereon. Depth information of subjects in an image may be extracted by using a high resolution cameras, out focusing of the image may be adjusted, or subjects in the image may be automatically identified.

In some example embodiments, the image sensor 2000 may be applied to a smart refrigerator, a security camera, a robot, a medical camera, etc. For example, the smart refrigerator may automatically recognize food in a refrigerator, by using an image sensor, and notify a user of the presence of a particular food or ingredient, the type of food that is input or output, etc., through a smartphone. The security camera may provide an ultrahigh resolution image and may recognize an object or a person in an image in a dark environment by using high sensitivity. The robot may be provided in a disaster or industrial site that is not directly accessible by people, and may provide a high resolution image. The medical camera may provide a high resolution image for diagnosis or surgery, and thus a field of vision may be dynamically adjusted.

In some example embodiments, the image sensor 2000 may be applied to a vehicle. The vehicle may include a plurality of vehicle cameras disposed at various positions. Each of the vehicle cameras may include the image sensor 2000 according to an example embodiment. The vehicle may provide a driver with various pieces of information about the inside or periphery of the vehicle, by using the vehicle cameras, thereby providing an object or a person in an image that is automatically recognized and information needed for autonomous driving.

The spectral filter described above may use a resonance structure having a constant cavity thickness and form various transmission wavelength bands.

The spectral filter described above may be used as various image sensors such as a multi-spectral sensor, etc.

**Claims**

1.  A spectral filter comprising:

    a first resonance structure; and
    a meta device disposed on the first resonance structure,
    the meta device comprising a plurality of first beam steering regions, in which an incidence angle of an incident light is adjusted differently to be emitted, wherein each first beam steering region of the plurality of first beam steering regions comprises a plurality of nanostructures, each nanostructure of the plurality of nanostructures having a shape dimension corresponding to a sub-wavelength of the incident light.

2.  The spectral filter of claim 1, wherein

    the first resonance structure includes a plurality of first resonator regions that exhibit a first resonance wavelength with respect to a vertically incident light,
    the plurality of first beam steering regions respectively face the plurality of first resonator regions, and
    at least one of the plurality of first resonator regions transmits a light in a wavelength band different from the first resonance wavelength.

3.  The spectral filter of claim 2, wherein the plurality of nanostructures in one first beam steering region are arranged according to an arrangement rule that is different from an arrangement rule of the plurality of nanostructures in another first beam steering region.

4.  The spectral filter of claim 2 or 3, wherein

    the spectral filter operates as a plurality of unit filters with a same number as a number of the plurality of first beam steering regions, and central transmission wavelengths respectively exhibited by the plurality of unit filters are the first resonance wavelength or less and fall within a range of 30 % or more of the first resonance wavelength.

5.  The spectral filter of any of claims 2 to 4, wherein the first resonance structure includes:

    a first reflector and a second reflector disposed to face each other and spaced apart from each other; and
    a cavity layer between the first reflector and the second reflector,
    in particular, wherein each of the first reflector and the second reflector independently includes a distributed Bragg reflector (DBR).

6.  The spectral filter of any of claims 2 to 5, further comprising:

    a second resonance structure including a plurality of second resonator regions that exhibit a second resonance wavelength with respect to a vertically incident light, the second resonance wavelength being different from the first resonance wavelength,
    wherein the meta device further includes a plurality of second beam steering regions respectively facing the plurality of second resonator regions, and
    wherein at least one of the plurality of second resonator regions transmits a light in a wavelength band different from the second resonance wavelength.

7.  The spectral filter of claim 6, wherein each of the first resonance structure and the second resonance structure independently includes:

    a first reflector and a second reflector disposed to face each other and spaced apart from each other; and
    a cavity layer between the first reflector and the second reflector.

8.  The spectral filter of claim 7, wherein a thickness of the cavity layer of the second resonance structure is different from a thickness of the cavity layer of the first resonance structure, and/or
    wherein the cavity layer of the second resonance structure includes a dielectric pattern, the dielectric pattern including two types of dielectrics having different refractive indices.

9. The spectral filter of claim 8, wherein a thickness of the cavity layer of the second resonance structure is equal to a thickness of the cavity layer of the first resonance structure,
in particular, wherein the cavity layer of the first resonance structure and the cavity layer of the second resonance structure have different effective refractive indices.

10. The spectral filter of any of claims claim 6 to 9, wherein

the spectral filter operates as a plurality of unit filters having different transmission wavelength bands, and
a number of the plurality of unit filters is a sum of a number of the first beam steering region and a number of the plurality of second beam steering regions.

11. The spectral filter of any of the preceding claims, further comprising:

a buffer layer disposed between the first resonance structure and the meta device and supporting the plurality of nanostructures of each first beam steering region, and/or
a band pass filter disposed between the first resonance structure and the meta device.

12. The spectral filter of any of the preceding claims, wherein the plurality of nanostructures of the meta device are arranged in two layers.

13. An image sensor comprising:

a sensor substrate comprising a plurality of light sensing cells, the plurality of light sensing cells being configured to sense a light; and
a plurality of spectral filters according to any of the preceding claims disposed on the sensor substrate.

14. The image sensor of claim 13, wherein
an arrangement of the plurality of nanostructures in a first beam steering region corresponding to a spectral filter located at a center region of the image sensor among the plurality of spectral filters is different from an arrangement of the plurality of nanostructures in a first beam steering region corresponding to a spectral filter located at a periphery of the image sensor.

15. An electronic device comprising:

a lens assembly; and
an image sensor according to claim 13 or 14.

# FIG. 1

# FIG. 2

EP 4 528 338 A1

# FIG. 3

# FIG. 4

# FIG. 5

# FIG. 6

# FIG. 7

EP 4 528 338 A1

FIG. 8

# FIG. 9

# FIG. 10

# FIG. 11

## FIG. 12

# FIG. 13

EP 4 528 338 A1

# FIG. 14

# FIG. 15

# FIG. 16

# FIG. 17

# FIG. 18

# FIG. 19

ELECTRONIC DEVICE—ED01

ED00

ED50 — INPUT DEVICE

ED55 — AUDIO OUTPUT DEVICE

ED60 — DISPLAY DEVICE

ED30 — MEMORY

ED32 — VOLATILE MEMORY

ED34 — NON-VOLATILE MEMORY

ED36 — INTERNAL MEMORY

ED38 — EXTERNAL MEMORY

ED40 — PROGRAM

ED46 — APPLICATION

ED44 — MIDDLEWARE

ED42 — OPERATING SYSTEM

ED89 — BATTERY

ED20 — PROCESSOR

ED90 — COMMUNICATION MODULE

ED88 — POWER MANAGEMENT MODULE

ED76 — SENSOR MODULE

ED77 — INTERFACE

ED97 — ANTENNA MODULE

ED70 — AUDIO MODULE

ED80 — CAMERA MODULE

ED99 — NETWORK

ED04 — ELECTRONIC DEVICE

ED08 — SERVER

EP 4 528 338 A1

# FIG. 20

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/301053 A1 (WANG XINGZE [US] ET AL) 24 September 2020 (2020-09-24) | 1-5,12, 13,15 | INV.<br>G02B1/00 |
| Y | * the whole document * | 6-11,14 | G02B5/28<br>G02B26/00 |
| Y | US 2022/065696 A1 (KIM HYOCHUL [KR] ET AL) 3 March 2022 (2022-03-03)<br>* paragraphs [0061] - [0160]; figures 11, 18-21 * | 6-11 | G02F1/21<br>G02B5/20 |
| Y | US 2022/326415 A1 (YUN SEOKHO [KR] ET AL) 13 October 2022 (2022-10-13)<br>* paragraphs [0088] - [0109]; figures 1-7 * | 14 | |
| A | US 2021/088694 A1 (LEE JEONGYUB [KR] ET AL) 25 March 2021 (2021-03-25)<br>* the whole document * | 1-15 | |
| A | WU SHANGLIANG ET AL: "Angular sensitivity for a Fabry-Perot structure incorporating different dielectric materials", PROCEEDINGS OF SPIE; [PROCEEDINGS OF SPIE ISSN 0277-786X VOLUME 10524], SPIE, US, vol. 10027, 4 November 2016 (2016-11-04), pages 1002718-1002718, XP060080960, DOI: 10.1117/12.2245123 ISBN: 978-1-5106-1533-5<br>* the whole document * | 1-15 | TECHNICAL FIELDS SEARCHED (IPC)<br><br>G02B<br>G02F<br>G01J<br>H10F |

-/--

The present search report has been drawn up for all claims

| Place of search | Date of completion of the search | Examiner |
|---|---|---|
| Munich | 14 January 2025 | Knorn, Raphaela |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

Application Number

EP 24 19 8420

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | YANG JINGYI ET AL: "Active optical metasurfaces: comprehensive review on physics, mechanisms, and prospective applications", REPORTS ON PROGRESS IN PHYSICS, INSTITUTE OF PHYSICS PUBLISHING, BRISTOL, GB, vol. 85, no. 3, 3 March 2022 (2022-03-03), XP020462323, ISSN: 0034-4885, DOI: 10.1088/1361-6633/AC2AAF [retrieved on 2022-03-03] * the whole document * ----- | 1-15 | |

**TECHNICAL FIELDS SEARCHED (IPC)**

The present search report has been drawn up for all claims

| Place of search | Date of completion of the search | Examiner |
|---|---|---|
| Munich | 14 January 2025 | Knorn, Raphaela |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**EP 4 528 338 A1**

## ANNEX TO THE EUROPEAN SEARCH REPORT
## ON EUROPEAN PATENT APPLICATION NO.

`EP 24 19 8420`

This annex lists the patent family members relating to the patent documents cited in the above-mentioned European search report.
The members are as contained in the European Patent Office EDP file on
The European Patent Office is in no way liable for these particulars which are merely given for the purpose of information.

14-01-2025

| Patent document cited in search report | Publication date | Patent family member(s) | | Publication date |
|---|---|---|---|---|
| US 2020301053 A1 | 24-09-2020 | US | 2020301053 A1 | 24-09-2020 |
| | | WO | 2020190306 A1 | 24-09-2020 |
| US 2022065696 A1 | 03-03-2022 | KR | 20210020469 A | 24-02-2021 |
| | | US | 2021048342 A1 | 18-02-2021 |
| | | US | 2022065696 A1 | 03-03-2022 |
| US 2022326415 A1 | 13-10-2022 | NONE | | |
| US 2021088694 A1 | 25-03-2021 | KR | 20210035554 A | 01-04-2021 |
| | | US | 2021088694 A1 | 25-03-2021 |

EPO FORM P0459

For more details about this annex : see Official Journal of the European Patent Office, No. 12/82